Europäisches Patentamt

European Patent Office

Office européen des brevets

(19)

(11) Veröffentlichungsnummer: **0 285 960**
**A1**

(12) **EUROPÄISCHE PATENTANMELDUNG**

(21) Anmeldenummer: 88105011.6

(22) Anmeldetag: 28.03.88

(51) Int. Cl.⁴: **H01L 39/12 , C04B 35/00**

(30) Priorität: 09.04.87 DE 3711975

(43) Veröffentlichungstag der Anmeldung:
**12.10.88 Patentblatt 88/41**

(84) Benannte Vertragsstaaten:
**CH DE FR GB IT LI SE**

(71) Anmelder: **Siemens Aktiengesellschaft Berlin und München**
**Wittelsbacherplatz 2**
**D-8000 München 2(DE)**

(72) Erfinder: **Wecker, Joachim, Dr.**
**Georg-Krauss-Strasse 2**
**D-8520 Erlangen(DE)**

(54) **Verfahren zur Herstellung eines keramischen Supraleiter-Materials mit hoher Sprungtemperatur.**

(57) Mit dem Verfahren ist ein keramisches Material herzustellen, wobei eine supraleitende Metalloxid-phase mit hoher Sprungtemperatur auf Basis des Stoffsystems Me1-Me2-Cu-O mittels einer Wärmebehandlung ausgebildet wird. Die Metallkomponenten Me1 und Me2 enthalten zumindest ein Seltenes Erdmetall oder Yttrium bzw. ein Erdalkalimetall. Mit dem Verfahren soll ein Aufbau von beliebig geformten Körpern aus den spröden Metalloxidphasen erleichtert werden. Hierzu ist erfindungsgemäß vorgesehen, daß eine Vorlegierung aus den beteiligten Metallkomponenten des Stoffsystems im gewünschten Konzentrationsverhältnis erschmolzen wird, daß dann aus dieser Schmelze der Vorlegierung ein amorphes oder feinkristallines Zwischenprodukt unter Anwendung einer Rascherstarrungstechnik ausgebildet wird und daß schließlich das Zwischenprodukt einer Oxidationsbehandlung bei gleichzeitiger Wärmebehandlung zur Ausbildung der gewünschten supraleitenden Metalloxidphase unter Vermeidung eines Aufschmelzens unterzogen wird.

EP 0 285 960 A1

## Verfahren zur Herstellung eines keramischen Supraleiter-Materials mit hoher Sprungtemperatur

Die Erfindung bezieht sich auf Verfahren zur Herstellung eines keramischen supraleitenden Materials, bei dem eine supraleitende Metalloxidphase mit hoher Sprungtemperatur auf Basis des Stoffsystems Me1-Me2-Cu(Kupfer)-O(Sauerstoff) mittels einer Wärmebehandlung ausgebildet wird, wobei die Metallkomponenten Me1 ein Seltenes Erdmetall (einschließlich Yttrium) und Me2 ein Erdalkalimetall zumindest enthalten. Ein entsprechendes Verfahren ist z.B. aus "Zeitschrift für Physik B - Condensed Matter", Band 66, 1987, Seiten 141 bis 146 zu entnehmen.

Supraleitende Metalloxidverbindungen auf der Basis Me1-Me2-Cu-O (Me1 = Seltene Erden einschließlich Y; Me2 = Erdalkalimetalle) mit hohen Sprungtemperaturen $T_c$ von beispielsweise 40 Kelvin oder 90 Kelvin werden bisher im allgemeinen auf pulvermetallurgischem Wege hergestellt (vgl. z.B. die genannte Veröffentlichung "Z.Phys.B"). Hierzu dienen als Ausgangsmaterialien Oxid-, Hydroxid-oder Carbonatpulver der beteiligten Metalle. Diese Pulver werden dann im gewünschten stöchiometrischen Verhältnis gemischt und anschließend durch Pressen kompaktiert. Der so erhaltene Preßling wird schließlich bei Temperaturen zwischen etwa 900 °C und 1100 °C an Luft oder in einem Sauerstoffstrom gesintert, wobei sich aus den Komponenten durch eine Festkörperreaktion die gewünschte supraleitende Hoch-$T_c$-Phase bildet. Die erforderlichen Glühzeiten liegen dabei typisch im Bereich zwischen 10 und 50 Stunden. Die so zu gewinnende supraleitende Phase hat im Falle von $(La-Me2)_2 CuO_{4-y}$ mit $y \geq 0$ $K_2NiF_4$-Struktur (vgl. die genannte Veröffentlichung "Z.Phys.B" oder "Japanese Journal of Applied Physics", Vol. 26, No. 2, Febr. 1987, Seiten L 123 und L 124). Demgegenüber wird im Falle von $YBa_2Cu_3O_{9-\delta}$ (mit $\delta \approx 2,1$) eine orthorhombische Einheitszelle angenommen. Die diese Phasen enthaltenden Materialien haben eine Struktur ähnlich einer Oxidkeramik.

Bei diesem bekannten pulvermetallurgischen Verfahren sind vielfach jedoch mehrmaliges Zermahlen der Sinterkörper, Mischen, Pressen und wiederholtes Sintern nötig, um insbesondere bei größeren Formkörpern eine ausreichende Homogenität zu gewährleisten. Außerdem sind die erforderlichen Glühzeiten verhältnismäßig lang.

Die bekannten Hoch-$T_c$-Metalloxidphasen sind sehr spröde und somit nur sehr schwer verformbar. Die Herstellung von entsprechenden Leitermaterialien, etwa zum Bau von Magnetspulen, ist deshalb auf pulvermetallurgischem Wege äußerst schwierig.

Aufgabe der vorliegenden Erfindung ist es deshalb, ein Verfahren der eingangs genannten Art anzugeben, mit dem ein Aufbau von beliebig geformten Körpern aus den genannten spröden Metalloxidphasen mit hoher Sprungtemperatur erleichtert wird und das dabei verhältnismäßig einfach durchzuführen ist.

Diese Aufgabe wird erfindungsgemäß dadurch gelöst, daß eine Vorlegierung aus den beteiligten Metallkomponenten des Stoffsystems im gewünschten Konzentrationsverhältnis erschmolzen wird, daß dann aus dieser Schmelze der Vorlegierung ein amorphes oder feinkristallines Zwischenprodukt unter Anwendung einer Rascherstarrungstechnik ausgebildet wird und daß schließlich das rascherstarrte Zwischenprodukt einer Oxidationsbehandlung bei gleichzeitiger Wärmebehandlung zur Ausbildung der gewünschten supraleitenden Metalloxidphase unterzogen wird, wobei stets Temperaturverhältnisse eingehalten werden, bei denen ein Aufschmelzen des Materials ausgeschlossen ist.

Die mit dieser Ausbildung des Verfahrens verbundenen Vorteile sind insbesondere darin zu sehen, daß das Zwischenprodukt aus den metallischen Ausgangskomponenten hinreichend duktil ist, so daß damit beliebig geformte Körper aufgebaut werden können. Das entsprechend verarbeitete Zwischenprodukt wird dann "in situ", d.h. im verformten und/oder in einem räumlichen Gebilde eingebauten Zustand, der besonderen Oxidationsbehandlung und Wärmebehandlung unterzogen. Da das Zwischenprodukt im allgemeinen niedrigschmelzende Eutektika aufweist, muß die Wärmebehandlung zunächst bei entsprechend niedriger Temperatur unterhalb der Schmelztemperatur dieser Eutektika begonnen werden. Die hierbei gleichzeitig durchgeführte Oxidationsbehandlung führt zur Ausbildung von Phasen mit höherer Schmelztemperatur. Schließlich erfolgt die Bildung der supraleitenden Phase durch Glühung in Anwesenheit von Sauerstoff bei hinreichend hohen Temperaturen. Die so durchzuführende Oxidations-und Temperaturbehandlung kann dabei durch kontinuierliche Temperaturänderung oder auch in mehreren diskreten Stufen erfolgen. Das mit diesem Verfahren zu erhaltende keramische Supraleiter-Material ist sehr feinkörnig. Dies ist im Hinblick auf die supraleitenden Eigenschaften des Materials sehr günstig. Außerdem ist - neben der Duktilität des Zwischenproduktes - von Vorteil, daß die rasch-erstarrte Vorlegierung eine homogene Verteilung der Metallatome im mikroskopischen Bereich gewährleistet. Dies und mit der Rascherstarrungstechnik zu erhaltende geringe Dicken des Zwischenproduktes begünstigen sowohl die Kinetik der Oxidation als auch die Bildung der gewünschten supraleitenden Oxidphase, so daß insgesamt wesentlich kürzere Zeiten und niedrigere Temperaturen als bei dem bekannten pulvermetallurgischen Verfahren notwendig sind. Die zur Bildung der supraleitenden Phase vorzunehmenden Glühtemperaturen liegen im allgemeinen zwischen 600 °C und 1100 °C.

Vorteilhafte Ausgestaltungen des erfindungsgemäßen Verfahrens gehen aus den Unteransprüchen hervor.

Die Erfindung wird nachfolgend anhand der Herstellung eines Me1-Me2-Cu-O-Materials noch weiter erläutert. Bei diesem metalloxidischen Werkstoff sind Me1 aus der Gruppe der Seltenen Erdmetalle wie z.B. Y oder La und Me2 aus der Gruppe der Erdalkalimetalle wie z.B. Ca, Sr oder Ba zu wählen. Dabei sollen die entsprechenden metallischen Ausgangskomponenten jeweils mindestens ein (chemisches) Element aus den genannten Gruppen enthalten oder jeweils aus diesem mindestens einen Element bestehen. Das heißt, Me1 und Me2 liegen vorzugsweise in elementarer Form vor. Gegebenenfalls sind auch Legierungen oder Verbindungen mit diesen Metallen als Ausgangsmaterialien geeignet; d.h. mindestens eines der genannten Elemente kann partiell durch ein anderes Element substituiert sein.

Als ein entsprechendes konkretes Ausführungsbeispiel sei das Stoffsystem La-Sr-Cu-O zugrundegelegt. Für eine erfindungsgemäße Herstellung des entsprechenden supraleitenden Materials mit hoher Sprungtemperatur werden zunächst die metallischen Komponenten La, Sr und Cu dieses Systems zu einer Vorlegierung der Zusammensetzung $La_{60}Sr_{6,7}Cu_{33,3}$ unter Argon in einer wassergekühlten Kupferkokille induktiv erschmolzen.

Die so erhaltene Schmelze der Vorlegierung wird anschließend mittels einer an sich bekannten Rascherstarrungstechnik in ein duktiles Zwischenprodukt überführt. Vorteilhaft kann hierzu das sogenannte "melt-spinning" (Schmelzspinnverfahren) vorgesehen werden, ein Verfahren, das aus der Herstellung amorpher Metallegierungen bekannt ist (vgl. z.B. "Zeitschrift für Metallkunde", Band 69, 1978, Heft 4, Seiten 212 bis 220). Dementsprechend wird unter einem Schutzgas wie z.B. Argon oder unter Vakuum die erschmolzene Vorlegierung durch eine Düse auf eine schnell rotierende Trommel gespritzt, wobei eine Bandform des Zwischen produktes erhalten wird. Die Umdrehungsgeschwindigkeit dieser beispielsweise aus Kupfer bestehenden Trommel liegt dabei typisch oberhalb von 30 m/s. Auf diese Weise werden hohe Abkühlungsgeschwindigkeiten gewährleistet, so daß im allgemeinen eine Kristallisation der Legierung unterdrückt und somit ein amorphes Gefüge der Vorlegierung ausgebildet wird.

Das so erhaltene, beispielsweise bandförmige Zwischenprodukt ist hinreichend duktil, so daß es gegebenenfalls mechanisch weiterverarbeitet oder mit ihm eine gewünschte Struktur wie z.B. ein Magnet aufgebaut werden kann.

Um daran anschließend die gewünschte supraleitende Metalloxidphase der $K_2NiF_4$-Struktur mit hoher Sprungtemperatur zu erhalten, wird zunächst das rasch-erstarrte Zwischenprodukt bei einer ersten Temperatur an Luft oder in Sauerstoff voroxidiert. Diese erste Temperatur ist dabei so zu wählen, daß ein Aufschmelzen der Vorlegierung des Zwischenproduktes bzw. von niedrig - schmelzenden Eutektika im System Cu-La vermieden wird. Da die Schmelztemperatur dieser Eutektika bei ungefähr 475 °C liegt, werden gemäß dem gewählten Ausführungsbeispiel als erste Temperatur etwa 430 °C vorgesehen. Bei dieser Wärmebehandlung kristallisiert auch das durch die Rascherstarrungstechnik erhaltene amorphe Gefüge, da die Kristallisationstemperatur bei etwa 95 °C liegt. Für die Voroxidationsbehandlung bei der ersten Temperatur reichen dabei Zeiten von etwa 3 Stunden aus.

Am Ende dieser Voroxidations-und Wärmebehandlung ist die Vorlegierung des Zwischenproduktes in eine Oxid-Legierung überführt, in der jedoch die gewünschte supraleitende Metalloxidphase praktisch noch nicht vorliegt. Diese Phase bildet sich nämlich für das als Ausführungsbeispiel gewählte Stoffsystem erst bei höheren Temperaturen aus. Deshalb muß noch eine weitere Oxidationsbehandlung, wiederum an Luft oder in einem Sauerstoffstrom, bei einer hinreichend hohen zweiten Temperatur vorgenommen werden. Auch hierbei soll ein Aufschmelzen des Materials vermieden werden. Im allgemeinen weisen aber die mit der ersten Temperaturbehandlung erhaltenen Oxide der Oxid-Legierung hinreichend hohe Schmelztemperaturen auf. Für das gewählte Stoffsystem sind Temperaturen oberhalb von 600°C notwendig. Vorteilhaft ist dabei, daß die erforderliche Glühzeit insbesondere bei höheren Glühtemperaturen verhältnismäßig kurz ist und beispielsweise nur eine Stunde beträgt.

Gemäß dem erläuterten Ausführungsbeispiel wurde davon ausgegangen, daß für die Oxidations- und Wärmebehandlung zur Ausbildung der gewünschten supraleitenden Metalloxidphase mit hoher Sprungtemperatur zwei diskrete Temperaturstufen vorgesehen werden. Ebenso ist es jedoch auch möglich, die Temperatur kontinuierlich zu erhöhen. Auf jeden Fall muß dabei aber ein Aufschmelzen des Materials zu jedem Zeitpunkt ausgeschlossen sein.

Im Anschluß an die Bildung der gewünschten supraleitenden Metalloxidverbindung können die optimalen supraleitenden Eigenschaften wie z.B. die maximale Sprungtemperatur $T_c$ gegebenenfalls noch durch eine weitere Wärmebehandlung eingestellt werden.

Ferner können zur Ausbildung des Zwischenproduktes auch andere bekannte Rascherstarrungstechniken wie z.B. die Ausbildung dünner Schichten durch Sputtertechniken oder die Herstellung von Metallpulvern durch Verdüsungstechniken eingesetzt werden.

Außerdem braucht das mit der gewählten Rascherstarrungstechnik hergestellte zwischenprodukt nicht unbedingt ein amorphes Gefüge zu haben. Ebenso kann auch ein feinkristallines Zwischenprodukt erfindungsgemäß weiterverarbeitet werden.

Will man statt des für das Ausführungsbeispiel gewählten Stoffsystems La-Sr-Cu-O das Stoffsystem Y-Ba-Cu-O erfindungsgemäß herstellen, so ist ein einfaches Erschmelzen der metallischen Komponenten schwer möglich, da Y und Ba in der Schmelze eine Mischungslücke bilden. In diesem Fall wird die Vorlegierung zweckmäßig auf anderem Wege als durch Erschmelzen erstellt. Entsprechende, insbesondere mechanische Verfahren sind allgemein bekannt. Ein so zu erhaltender Körper aus der Vorlegierung dient dann als Ausgangsmaterial für die Rascherstarrung. Hierbei wird zwar der Körper auch wieder aufgeschmolzen; da aber sowohl dieses Aufschmelzen als auch die sich daran anschließende Rascherstarrung sehr schnell ablaufen, kann es dabei nicht mehr zu einer makroskopischen Entmischung der Komponenten der Schmelze kommen.

Bei einer erfindungsgemäßen Herstellung des Stoffsystems Y-Ba-Cu-O treten ferner während der Voroxidation des rasch-erstarrten Zwischenproduktes ebenfalls niedrig-schmelzende Eutektika im ternären Stoffsystem Cu-Y-Ba auf. In diesem Falle reicht im allgemeinen nach der Voroxidation bei einer ersten Temperatur knapp unterhalb von etwa 700 °C eine geringfügige Temperaturerhöhung um beispielsweise 100 °C bis 200 °C aus, um die gewünschte supraleitende Metalloxidphase auszubilden.

Abweichend von dem dargestellten Ausführungsbeispiel eignet sich das Verfahren nach der Erfindung ebenso auch für Stoffsysteme Me1-Me2-Cu-O, deren elementare Metallkomponenten Me1 und Me2 partiell durch andere Elemente substituiert sind, wobei jedoch im allgemeinen der Anteil der genannten Elemente gegenüber dem Substitutionselement jeweils überwiegt. So können beispielsweise in dem Stoffsystem La-Sr-Cu-O das La durch Al, das Sr durch Ba oder Ca und das Cu durch Hg oder Ag teilweise substituiert werden. Ebenso kann man in dem System Y-Ba-Cu-O das Y teilweise durch Al ersetzen. Darüber hinaus können für die metallischen Komponenten Me1 und Me2 auch andere Metalle aus den für diese Komponenten jeweils genannten Gruppen geeigneter Materialien gewählt werden.

## Ansprüche

1. Verfahren zur Herstellung eines keramischen supraleitenden Materials, bei dem eine supraleitende Metalloxidphase mit hoher Sprungtemperatur auf Basis des Stoffsystems Me1-Me2-Cu(Kupfer)-O(Sauerstoff) mittels einer Wärmebehandlung ausgebildet wird, wobei die Metallkomponenten Me1 ein Seltenes Erdmetall einschließlich Y (Yttrium) und Me2 ein Erdalkalimetall zumindest enthalten, **dadurch gekennzeichnet,** daß eine Vorlegierung aus den beteiligten Metallkomponenten des Stoffsystems im gewünschten Konzentrationsverhältnis erschmolzen wird, daß dann aus dieser Schmelze der Vorlegierung ein amorphes oder feinkristallines Zwischenprodukt unter Anwendung einer Rascherstarrungstechnik ausgebildet wird und daß schließlich das rasch-erstarrte Zwischenprodukt einer Oxidationsbehandlung bei gleichzeitiger Wärmebehandlung zur Ausbildung der gewünschten supraleitenden Metalloxidphase unterzogen wird, wobei stets Temperaturverhältnisse eingehalten werden, bei denen ein Aufschmelzen des Materials ausgeschlossen ist.

2. Verfahren nach Anspruch 1, **dadurch gekennzeichnet,** daß ein Zwischenprodukt in Bandform ausgebildet wird.

3. Verfahren nach Anspruch 1 oder 2, **dadurch gekennzeichnet,** daß das Zwischenprodukt vor der Oxidations-und Wärmebehandlung mechanisch weiterverarbeitet wird.

4. Verfahren nach einem der Ansprüche 1 bis 3, **dadurch gekennzeichnet,** daß mit dem Zwischenprodukt ein räumliches Gebilde aufgebaut wird, in dem anschließend das Zwischenprodukt der Oxidations-und Wärmebehandlung unterzogen wird.

5. Verfahren nach Anspruch 4, **dadurch gekennzeichnet,** daß die Oxidations-und Wärmebehandlung in situ in einem Magneten als räumlichem Gebilde vorgenommen wird.

6. Verfahren nach einem der Ansprüche 1 bis 5, **dadurch gekennzeichnet,** daß für die Oxidations-und Wärmebehandlung mehrere Temperaturstufen unter Berücksichtigung des momentanen Oxidationsgrades vorgesehen werden.

7. Verfahren nach Anspruch 6, **dadurch gekennzeichnet,** daß die Temperatur kontinuierlich geändert wird.

8. Verfahren nach einem der Ansprüche 1 bis 7, **dadurch gekennzeichnet,** daß zur Herstellung eines Vorproduktes des Stoffsystems Y-Ba-Cu-O die Komponenten mechanisch zu einer Legierung vereinigt werden.

9. Verfahren nach einem der Ansprüche 1 bis 8 , **dadurch gekennzeichnet,** daß im Anschluß an die Oxidations-und Wärmebehandlung zur Ausbildung der supraleitenden Metalloxidphase eine weitere Wärmebehandlung vorgenommen wird.

10. Verfahren nach einem der Ansprüche 1 bis 9, **dadurch gekennzeichnet,** daß zumindest eines der Metalle der Vorlegierung durch ein weiteres Metall teilweise substituiert wird.

11. Verfahren nach Anspruch 10, **dadurch gekennzeichnet,** daß das La oder Y der ersten Metallkomponente Me1 teilweise durch Al-(Aluminium) substituiert wird.

12. Verfahren nach Anspruch 10 oder 11, **dadurch gekennzeichnet,** daß das Ba oder Sr oder Ca der zweiten Metallkomponente teilweise durch ein anderes Metall aus der Gruppe der genannten Metalle substituiert wird.

13. Verfahren nach einem der Ansprüche 10 bis 12, **dadurch gekennzeichnet,** daß das Cu teilweise durch Hg (Quecksilber) oder Ag (Silber) substituiert wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | JAPANESE JOURNAL OF APPLIED PHYSICS, Band 26, Nr. 4, April 1987, Seiten L334-L336, Tokyo, JP; K. MATSUZAKI et al.: "Preparation of a high Tc superconductor by oxidization of an amorphous La1.8Sr0.2Cu alloy ribbon in Air" * Das ganze Dokument * | 1-9 | H 01 L 39/12 C 04 B 35/00 |
| A | IDEM ----- | 10-13 | |
| | | | RECHERCHIERTE SACHGEBIETE (Int. Cl.4) |
| | | | H 01 L C 04 B |

Der vorliegende Recherchenbericht wurde für alle Patentansprüche erstellt

| Recherchenort | Abschlußdatum der Recherche | Prüfer |
|---|---|---|
| DEN HAAG | 06-07-1988 | SCHURMANS H.D.R. |

EPO FORM 1503 03.82 (P0403)